**Europäisches Patentamt**

(19) **European Patent Office**

**Office européen des brevets**

(11) Publication number : **0 218 326 B1**

(12) # EUROPEAN PATENT SPECIFICATION

(45) Date of publication of patent specification :
05.06.91 Bulletin 91/23

(51) Int. Cl.⁵ : **G11C 27/02**

(21) Application number : **86305985.3**

(22) Date of filing : **04.08.86**

(54) DC-DC impedance transformer for a sample and hold circuit.

(30) Priority : **05.08.85 US 762254**

(43) Date of publication of application :
**15.04.87 Bulletin 87/16**

(45) Publication of the grant of the patent :
**05.06.91 Bulletin 91/23**

(84) Designated Contracting States :
**DE FR GB**

(56) References cited :
**PROCEEDINGS OF THE INSTITUTION OF
ELECTRICAL ENGINEERS, vol. 115, no. 12,
December 1968, pages 1871-1877, New York,
US; G.F. TURNBULL et al.: "Design of an
accurate sampled-data simulator using
field-effect transistors"**

(73) Proprietor : **Wavetek Corporation
9145 Balboa Avenue
San Diego California 92123 (US)**

(72) Inventor : **Hubbs, John Charles
1295 Fremont Terrace West
Sunnyvale California 94087 (US)**

(74) Representative : **Bubb, Antony John Allen et al
GEE & CO. Chancery House Chancery Lane
London WC2A 1QU (GB)**

## Description

The invention relates generally to a circuit for sampling a rapidly varying voltage and holding the sample voltage for a predetermined period of time, and more particularly to such a circuit which provides improved voltage and power gain with low noise.

In many systems, especially those used to sample an input video signal, the high speed and accuracy required in the overall system is commonly limited by the performance of the sample-and-hold apparatus. For example, settling time must be allowed, jitter prevented, and the effects of temperature taken into account. While sampling is taking place, the circuit has an inherent limitation in that sampling may require switching or a change of impedance condition which has a tendency to produce jitter, or alternatively, increase the settling time by producing a ringing effect. Also, an increase in circuit noise may occur because of the change of impedance on the input circuit.

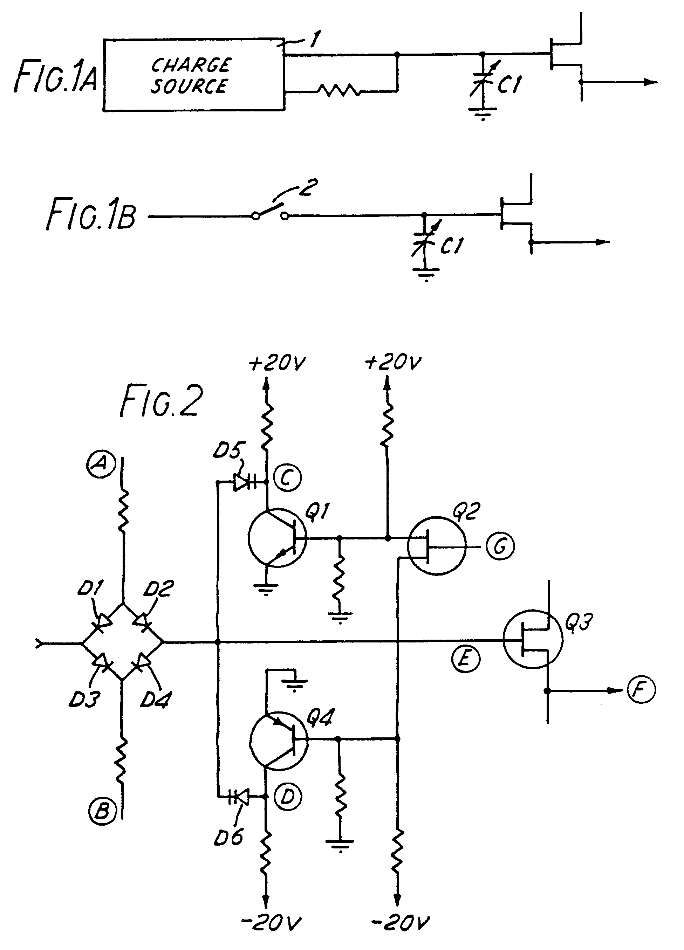

In a data acquisition system where the data to be acquired comes from an infinite impedance source as shown in Figure 1A, at 1, or a perfect switch or sampling system as in Figure 1B, at 2, charge sensitivity and charge noise will ultimately be limited by the input capacitance and noise of the measurement system. This measurement system is shown in Figures 1A and 1B as a single FET buffer or impedance converter, wherein the optimum value of capacitor C1 is zero. Further particulars of such systems are also described in "Proceedings of the Institution of Electrical Engineers Vol 115 N° 12 December 1968 pages 1871-1877".

For imperfect switches or sampling systems, or for charge sources with less than infinite source impedance, however, it is often desirable and sometimes necessary to store the transfer charge in capacitor C1 whose value is considerably larger than that of the measurement system. In particular, in existing sampling oscilloscopes made by Tektronix, HP, Autek or EH Electronics, the capacitor of the sampling circuit labelled C1 is many times larger than the input capacitance of commercially available FETs which are incorporated as a part of the output circuit of the sample-and-hold circuit. For example, in order to minimise blow-by and blow-out in sampling systems using commercially available diodes, capacitor C1 is typically of the order of 5 pF, while a commercial FET typically has an effective input capacity of only .04 pF. Thus, there is a noise or impedance mismatch of up to two decades in presently available sampling oscilloscopes. The terms "blow by" and "blow out" used herein will understood by those skilled in the art to describe dynamic switch imperfections resulting in corruption of the output signal.

It is an objective of the present invention to reduce the noise in, and provide an accurately amplified version of the sample signal to the output circuit.

This and other objectives and advantages of the present invention are provided in a circuit in accordance with the characterising features of Claim 1.

The invention is illustrated by way of exemple in the the accompanying drawings, in which :

Figures 1A and 1B are circuit diagrams illustrating prior art approaches to the problem ;

Figure 2 is a detailed diagram of the circuit of the present invention ; and

Figure 3 is a timing diagram of the input, output and control signals of the present invention.

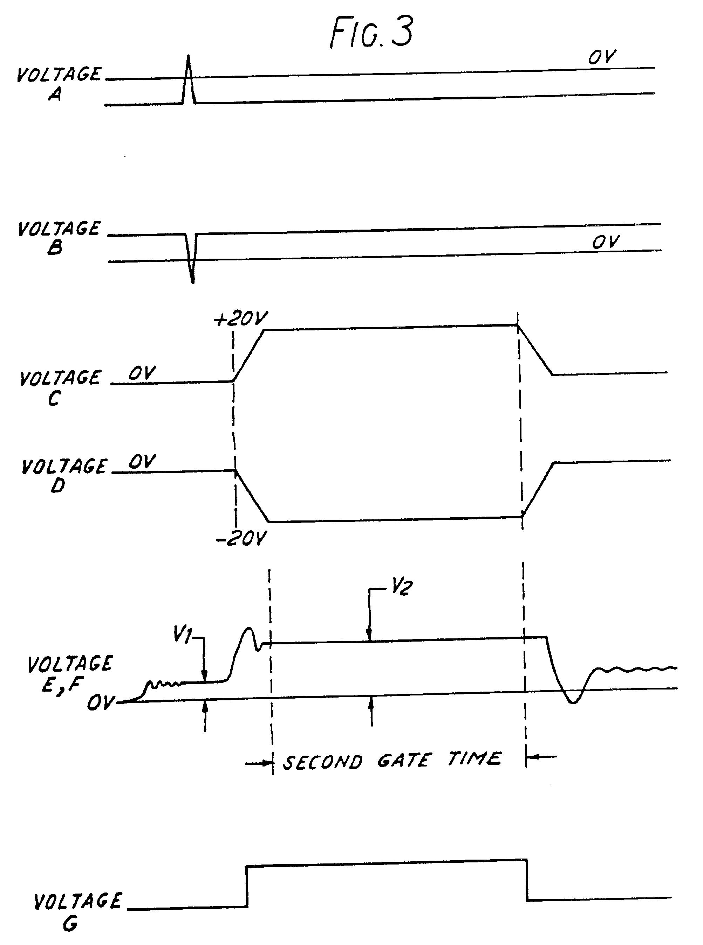

Referring now to Fig. 2, the input circuit which comprises a diode bridge formed of diodes D1-D4, is strobed to sample the input signal V1. The strobe signal voltages A, B are shown at the top of Fig. 3 and are of relatively brief duration to sample the incoming voltage V1 shown in the fifth line of Fig. 3 (voltage E, F). The bandwidth of the sampling system is determined to a first order by the width of the strobe pulses at points A and B. In particular, the rise time of the sample pulse will be approximately the width of the strobe pulse at the voltage point where the diodes begin and end conduction.

The charge transferred from the input signal is stored in varactor diodes D5, D6, although some small amount of the charge may be stored in the input capacitance of FET Q3 and stray circuit capacitances. However, at this point, since the capacitances of the varactor diodes D5, D6 are variable, they are set at a first higher level to minimise the charge lost to stray circuit capacitances.

After the completion of the bridge strobes A, B, a second signal shown as voltage G is initiated and applied to the gate of FET Q2 to turn on this FET. This FET is coupled to the bases of two bipolar transistors of opposite conductivity type, Q1 and Q4. Turning on this transistor removes the input current from the bases of transistors Q1 and Q4 so that they switch from a very low impedance state (circa 5 ohms) to open circuit, allowing a balanced back biasing of varactors D5 and D6 to occur. This reduces the capacitance of varactor diodes D5, D6 to a value which preferably approaches as nearly as possible the input capacitance of FET Q3 of the output circuit.

At the end of the capacitance transition time of varactor diodes D5, D6 (which is indicated by the dotted line which appears in Fig. 3 at voltages C, D and F), an amplified version of the strobed input voltage now appears as voltage V2 at the output F of FET Q3. At the end of this amplification process, the initial voltage V1 at FET Q3 is amplified to an output value V2, and the voltage gain V2/V1 is found to be about 7, in excellent agreement with the theoretical gain derived from charge conservation and measured C(V). A typical varactor is Philips BBY31 ; a typical input FET used as transistor Q3 is Telmos SD211.

Since the positive-going collector voltage at transistor Q4, the negative-going collector voltage at transistor Q1, and varactor diodes D5 and D6 are not perfectly matched, there will be 'glitches' in the output voltage from transistor Q3, but these are observed to be of the order of 100 millivolts and occur only during the capacitance transition time of the varactor diodes D5, D6. According to test, they appear to cease when the collector of transistor Q1 arrives at +20 volts, and the collector of transistor Q4 arrives at –20 volts.

In summary, the disclosed circuit functions as a DC-DC impedance transformer or charge pump, and has been shown to have a high-speed reaction time, and provide a relatively noise-free output comprising an amplified version of the sampled input. Modifications of the disclosed preferred embodiment may occur to a person of skill in the art who studies the subject invention disclosure. Therefore, the scope of the present invention is to be limited only by the following claims.

## Claims

1. A circuit for sampling and holding a voltage of a waveform signal (V1) including an input for receiving the signal, means (D1-D4) connected to said input for periodically sampling the signal, storage capacitor means (D5, D6) for storing a voltage corresponding to the sampled portion of the signal, and means (Q3) for reading out the value stored on the storage capacitor, characterised in that said storage capacitor means comprises a pair of voltage variable capacitors (D5, D6) having a common node (E) coupled to said sampling means (D1-D4), and that means (Q2, Q1, Q4) is provided for applying balanced control pulses to the other nodes (C, D) of said capacitors (D5, D6), whereby their capacitance is set to a first upper level during a sampling period of said sampling means and to a second lower level during a read period of said sample circuit, and whereby said read out means (Q3) provides at its output an amplified version (V2) of said imput signal (V1).

2. A circuit as claimed in Claim 1 characterised in that said capacitance setting means (Q2, Q1, Q4) comprises a pair of oppositely biased complementary type transistors (Q1, Q4), and a control swhich (Q2) coupled to the control nodes of said transistors (Q1, Q4).

3. A circuit as claimed in Claim 2, wherein said control switch (Q2) comprises an FET coupled between the control nodes of said two complementary transistors (Q1, Q4) and responsive to an imput signal (G) to alter the capacitance of the voltage variable capacitance means (D5, D6) from the first upper level to the second lower level.

4. A circuit as claimed in any one of Claim 1-3 characterised in that said read out means (Q3) comprises and FET having an input capacitance, the second level of said voltage variable capacitance means (D5, D6) being near to said FET input capacitance.

5. A circuit as claimed in any one of Claims 1-4 characterised in that said sampling means comprises a diode bridge (D1-D4) connected between the signal input and the read out means (Q3), and control means for periodically strobing the bridge to sample the input signal.

## Ansprüche

1. Schaltkreis zum Abtasten und Halten der Spannung eines wellenförmigen Signals (V1), bestehend aus einem Eingang zum Empfangen des Signals, aus mit diesem Eingang verbundenen Bauelementen (D1-D4) zum periodischen Abtasten des Signals, aus Speicherkondensatorelementen (D5, D6) zum Speichern einer mit dem Abtastwert des Signals korrespondierenden Spannung, und aus einem Hilfsmittel (Q3) zum Auslesen des in den Speicherkondensatorelementen gespeicherten Werts, dadurch gekennzeichnet, daß die Speicherkondensatorelemente aus einem Paar von Kapazitätsdioden (D5, D6) mit einem gemeinsamen, mit den Abtastmitteln (D1-D4) verbundenen Netzwerkknoten (E) bestehen, und daß Bauelemente (Q2, Q1, Q4) zum Anlegen symmetrischer Kontrollimpulse an die anderen Anschlüsse (C, D) der Kapazitätsdioden (D5, D6) vorgesehen sind, wobei deren Kapazität während einer Abtastperiode der Abtastelemente auf einen ersten, oberen Wert und während einer Leseperiode des Abtastkreises auf einen zweiten, niedrigeren Wert eingestellt ist und das Ausleseelement (Q3) an seinem Ausgang eine verstärkte Version (V2) des Eingangssignals (V1) zur Verfügung stellt.

2. Schaltkreis nach Anspruch 1, dadurch gekennzeichnet, daß die Bauelemente (Q2, Q1, Q4) zum Einstellen der Kapazität ein Paar von entgegengesetzt vorgespannten komplementären Transistoren (Q1, Q4) und einen an die Steueranschlüsse der Transistoren (Q1, Q4) gekoppelten Kontrollschalter (Q2) umfassen.

3. Schaltkreis nach Anspruch 2, dadurch gekennzeichnet, daß der Kontrollschalter (Q2) eine zwischen die Steueranschlüsse der beiden komplementären Transistoren (Q1, Q4) geschalteten FET aufweist, welcher als Reaktion auf ein Eingangssignal (G) die Kapazität der Kapazitätsdioden (D5, D6) von dem ersten, oberen Wert auf den zweiten, niedrigeren Wert ändert.

4. Schaltkreis nach einem der Ansprüche 1 bis 3, dadurch gekennzeichnet, daß das Ausleseelement (Q3) aus einem FET besteht, dessen Eingangskapazität in der Nähe des zweiten Wertes der Kapazitätsdioden (D5, D6) liegt.

5. Schaltkreis nach einem der Ansprüche 1 bis 4, dadurch gekennzeichnet, daß die Abtastelemente eine zwischen dem Signaleingang und dem Ausleseelement (Q3) angeschlossene Diodenbrücke (D1-D4) sowie Kontrollelemente zum periodischen, stroboskopischen Sensibilisieren der Brücke zum Abtasten des Eingangssignals aufweisen.

## Revendications

1. Circuit pour échantillonner et maintenir une tension d'un signal de forme d'onde (V1), comprenant une entrée pour recevoir le signal des moyens (D1-D4) raccordés à cette entrée pour échantillonner périodiquement le signal des moyens de condensateurs de stockage (D5, D6) pour stocker une tension correspondant à la tension échantillonnée du signal, et des moyens (Q3) pour lire la valeur stockée sur le condensateur de stockage, caractérisé en ce que les moyens de condensateurs de stockage comprennent deux condensateurs à capacité variable (D5, D6) ayant un noeud commun (E) couplé aux moyens d'échantillonnage (D1-D4) et en ce que des moyens (Q2, Q1, Q4) sont prévus pour appliquer des impulsions de commande en phase aux autres noeuds (C, D) de ces condensateurs (D5, D6), d'où il résulte que leur capacité est réglée à une première valeur élevée lors d'une période d'échantillonnage des moyens d'échantillonnage et à une deuxième valeur basse lors d'une période de lecture du circuit d'échantillonnage, et d'où il résulte égalaient que les moyens de lecture (Q3) fournissent à leur sortie une version amplifiée (V2) du signal d'entrée (V1).

2. Circuit selon la revendication 1, caractérisé en ce que les moyens de réglage de la capacité (Q2, Q1, Q4) comprennent deux transistors (Q1, Q4) de type complémentaire polarisés en opposition, et un commutateur de commande (Q2) couplé aux noeuds de commande de ces transistors (Q1, Q4).

3. Circuit selon la revendication 2, dans lequel ce commutateur de commande (Q2) est un transistor à effet de champ monté entre les noeuds de commande des deux transistors complémentaires (Q1, Q4) et sensible à un signal d'entrée (G) pour modifier la capacité des condensateurs à capacité variable (D5, D6) de la première valeur élevée à la deuxième valeur basse.

4. Circuit selon l'une quelconque des revendications 1 à 3, caractérisé en ce que les moyens de lecture (Q3) sont un transistor à effet de champ ayant une capacité d'entrée, la deuxième valeur des condensateurs à capacité variable (D5, D6) étant proche de cette capacité d'entrée du transistor à effet de champ.

5. Circuit selon l'une quelconque des revendications 1 à 4, caractérisé en ce que les moyens d'échantillonnage comprennent un point à diodes (D1-D4) monté entre l'entrée des signaux et les moyens de lecture (Q3), et des moyens de commande pour explorer périodiquement le pont afin d'échantillonner le signal d'entrée.

FIG.1A

FIG.1B

FIG.2

# FIG.3

VOLTAGE A ....... 0V

VOLTAGE B ....... 0V

+20V
VOLTAGE C  0V
VOLTAGE D  0V
-20V

V1  V2
VOLTAGE E,F  0V

SECOND GATE TIME

VOLTAGE G

6